# EUROPEAN PATENT APPLICATION

(11) **EP 4 814 522 A1**
(43) Date of publication of application: **30.09.2026**
(21) Application number: 26168278.5
(22) Date of filing: 26.03.2026
(51) Int. Cl.: G01R 33/34, G01R 33/3415

(54) **COIL SYSTEM WITH A FLEXIBLE BLANKET-TYPE COIL UNIT AND AN DETACHABLE FIXING AUXILIARY MEMBER**

(30) Priority: 28.03.2025 JP 2025056487
(71) Applicant: FUJIFILM Corporation, Tokyo 106-8620 (JP)
(72) Inventor: ARAI, Koichi, Tokyo (JP); OTAKE, Yosuke, Tokyo (JP); IWASAWA, Kohjiro, Tokyo (JP); MATSUMURA, Kiyoshi, Tokyo (JP); OGI, Kazuyuki, Tokyo (JP); KYOTANI, Katsusuke, Tokyo (JP); KATO, Kazuyuki, Tokyo (JP); TANIGUCHI, Takeshi, Tokyo (JP)
(74) Representative: Dehns Germany Partnerschaft mbB

(57) **Abstract**

A coil system (10) that can easily perform a fixing operation and can increase a degree of close contact between a coil unit (100, 130) and a subject (99). The coil system (10) includes a flexible blanket-type coil unit (100, 130) that is wound around a subject (99) when acquiring a magnetic resonance image, and a fixing auxiliary member (110L, 110R, 120, 120L, 120R, 121) that is attachable to and detachable from the blanket-type coil unit (100, 130) and that is used for fixing the blanket-type coil unit (100, 130) in a state where the blanket-type coil unit (100, 130) is wound around the subject (99), in which the blanket-type coil unit (100, 130) is provided with a first fixing member (100A, 100B, 100C, 100D) for connection to the fixing auxiliary member (110L, 110R, 120, 120L, 120R, 121), the fixing auxiliary member (110L, 110R, 120, 120L, 120R, 121) is provided with a second fixing member (110A, 110B, 110C, 110D, 120A, 120B, 120C, 120D) for connection to the blanket-type coil unit (100, 130), and the blanket-type coil unit (100, 130) and the fixing auxiliary member (110L, 110R, 120, 120L, 120R, 121) are fixed to each other by fixing the first fixing member (100A, 100B, 100C, 100D) and the second fixing member (110A, 110B, 110C, 110D, 120A, 120B, 120C, 120D).

## Description

### BACKGROUND OF THE INVENTION

### 1. Field of the Invention

The present invention relates to a coil system that is used in a magnetic resonance imaging apparatus.

### 2. Description of the Related Art

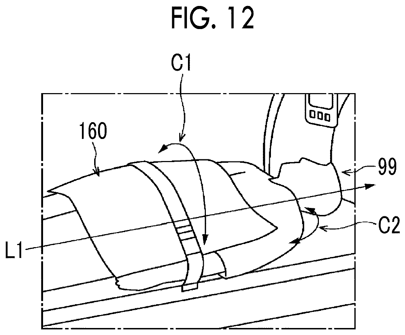

During imaging in a magnetic resonance imaging (MRI) apparatus, a receive coil having a rectangular planar shape is known. In order to efficiently acquire signals from a patient (subject) having a substantially cylindrical or elliptical cylindrical cross section, such a receive coil is wound around an axis along a body axis of the patient (an axis parallel to the body axis of the patient) and is disposed in a curved shape. FIG. 12 is a schematic diagram illustrating a state where such a receive coil unit in the related art is wound around a subject. The same drawing illustrates a state where a rectangular receive coil 160 (for example, an abdominal receive coil) is wound around a subject 99 along a curved surface C1 having a body axis L1 as an axis. Such a receive coil unit is fixed to the subject by a separate belt, for example, as illustrated in FIG. 12.

In addition, a receive coil unit in which a belt is provided in order to easily fix the receive coil unit to the subject is known (for example, see JP2012-105805A and JP2011-101694A).

### SUMMARY OF THE INVENTION

In the abdominal receive coil in the related art illustrated in FIG. 12, the belt is separate, and the subject is in a state of lying down on a bed, so that a fixing operation is complicated. Specifically, it is difficult for an operator to grasp the belt extending from a rear side (a side opposite to the bed) of the subject lying down, and in some cases, the operator needs to walk around the bed. In addition, the belt is often provided with a minimum length in order not to be entangled with wiring of a staff call system (so-called "nurse call") or the like on the bed, and in this case, it is difficult to fix the receive coil unit to the subject having a plurality of curved surfaces (in the example of FIG. 12, a curved surface C1 having a body axis L1 as an axis and a curved surface C2 having an axis in a direction different from the body axis).

In response to such a situation, in the technique disclosed in JP2012-105805A, the belt attached to the coil is present, so that the coil can be fixed to the subject in advance. In addition, in the technique disclosed in JP2011-101694A, a coil holding unit is present, so that the coil can be fixed along the body axis (around a waist) of the subject. However, these techniques can only accommodate fixation at specific times (before or after the subject lies down on the bed) or directions (curved surface of the subject).

The present invention has been made in view of such circumstances, and an object of the present invention is to provide a coil system that can easily perform a fixing operation and can increase a degree of close contact between a coil unit and a subject.

In order to achieve the above-described object, a first aspect of the present invention relates to a coil system comprising: a flexible blanket-type coil unit that is wound around a subject in a case of acquiring a magnetic resonance image; and a fixing auxiliary member that is attachable to and detachable from the blanket-type coil unit and that is used for fixing the blanket-type coil unit in a state where the blanket-type coil unit is wound around the subject, in which the blanket-type coil unit is provided with a first fixing member for connection to the fixing auxiliary member, the fixing auxiliary member is provided with a second fixing member for connection to the blanket-type coil unit, and the blanket-type coil unit and the fixing auxiliary member are fixed to each other by fixing the first fixing member and the second fixing member.

According to the first aspect, the coil unit can be fixed in a state where the coil unit is in close contact with the subject by the fixing auxiliary member (harness). Since the fixing auxiliary member is attachable to and detachable from the blanket-type coil unit, the operability is good.

A first embodiment relates to the coil system according to the first aspect, in which the blanket-type coil unit is provided with the first fixing members at at least four locations in total, including both end portions in a body axis direction in a case where the blanket-type coil unit is wound around the subject and both end portions in a direction intersecting the body axis direction, the fixing auxiliary member is provided with the second fixing members at at least four locations in total, including both end portions in the body axis direction in a case where the fixing auxiliary member is wound around the subject and both end portions in the direction intersecting the body axis direction, positions of the second fixing members correspond to positions of the first fixing members, and the blanket-type coil unit and the fixing auxiliary member are fixed to each other by coupling the first fixing members and the second fixing members. According to the first embodiment, the fixing auxiliary member and the coil unit are fixed to each other at at least four locations in total, so that the degrees of fixing by these fixing members can be individually adjusted, and it is easy to adjust the winding manner in accordance with a body shape even in a state where the subject lies down on the bed with the coil system wound around the subject. In the first embodiment and each of the following embodiments, "both end portions" do not necessarily mean both ends in a strict sense.

A second embodiment relates to the coil system according to the first embodiment, in which a distance between the second fixing members at both end portions of the fixing auxiliary member in the body axis direction is shorter than a distance between the first fixing members at both end portions of the blanket-type coil unit in the body axis direction. According to the second embodiment, the coil unit can be easily pulled in by a short fixing auxiliary member, and can be easily adjusted to fit the body of the subject.

A third embodiment relates to the coil system according to any one of the first aspect or first to second embodiments, in which the first fixing member and the second fixing member are hook-and-loop fasteners. The third embodiment defines a specific aspect of the fixing member.

A fourth embodiment relates to the coil system according to any one of the first aspect or first to third embodiments, in which the fixing auxiliary member is composed of a plurality of fixing auxiliary members, and the plurality of fixing auxiliary members are fixed to each other by a third fixing member. The third fixing member may be the hook-and-loop fastener, but the present invention is not limited to this aspect.

A fifth embodiment relates to the coil system according to any one of the first aspect or first to fourth embodiments, in which the fixing auxiliary member has a fourth fixing member for fixing the coil system to a bed of a magnetic resonance imaging apparatus. According to the fifth embodiment, the fixing auxiliary member can be fixed to the bed in advance, and it is easy to respond to the subject who has difficulty in performing an operation of attaching the coil system while standing (or with his/her upper body raised). The fourth fixing member may be the hook-and-loop fastener, but the present invention is not limited to this aspect.

A sixth embodiment relates to the coil system according to any one of the first aspect or first to fifth embodiments, in which the fixing auxiliary member has a mesh structure region. According to the sixth embodiment, the ventilation property is improved, and it is possible to reduce the possibility that the subject unintentionally moves due to discomfort and affects the imaging.

A seventh embodiment relates to the coil system according to any one of the first aspect or first to sixth embodiments, in which a recess is formed on a head side of the subject in a case where the blanket-type coil unit is wound around the subject. According to the seventh embodiment, the coil unit can be brought into close contact with the head (around the neck) of the subject.

An eighth embodiment relates to the coil system according to any one of the first aspect or first to seventh embodiments, in which the blanket-type coil unit is provided with a pair of first slits at facing positions, and is deformable into a plurality of curved surfaces having different axes on both sides of the first slits. According to the eighth embodiment, the coil unit can be deformed to fit the body shape of the subject, and can be brought into close contact with the subject.

A ninth embodiment relates to the coil system according to the eighth embodiment, in which the pair of first slits are present on the same straight line. The "same straight line" does not necessarily mean "the same" in a strict sense.

A tenth embodiment relates to the coil system according to the eighth or ninth embodiments, in which the pair of first slits are provided in a direction intersecting a body axis of the subject in a case where the blanket-type coil unit is wound around the subject. According to the tenth embodiment, the coil unit is deformable into a curved surface along the body axis direction and a curved surface having the axis in the direction intersecting the body axis on both sides of the first slits. The "direction intersecting the body axis of the subject" is, for example, a direction orthogonal to the body axis direction of the subject, but does not necessarily mean an orthogonal direction in a strict sense.

An eleventh embodiment relates to the coil system according to any one of the eighth to tenth embodiments, in which in a case where the blanket-type coil unit is wound around the subject, the blanket-type coil unit is deformable into a first curved surface having an axis in a body axis direction of the subject in one region of the first slits, and is deformable into a second curved surface having an axis in a direction intersecting the axis of the first curved surface in the other region of the first slits. The "direction intersecting the axis of the first curved surface" is, for example, a direction orthogonal to the axis of the first curved surface, but does not necessarily mean "orthogonal" in a strict sense.

A twelfth embodiment relates to the coil system according to any one of the eighth to eleventh embodiments, in which a recess is formed in the blanket-type coil unit on a head side of the subject in a case where the blanket-type coil unit is wound around the subject, and the pair of first slits are provided on a leg side of the subject in a case where the blanket-type coil unit is wound around the subject, with respect to a bottom portion of the recess. According to the twelfth embodiment, the coil unit is easily deformed along the head side of the subject and easily deformed along an abdominal side on both sides of the first slit, and the degree of close contact with the subject can be improved.

A thirteenth embodiment relates to the coil system according to any one of the eighth to twelfth embodiments, in which a groove is provided in a direction of an axis of at least one curved surface among the plurality of curved surfaces, and a curved surface having a vertex at the groove is formed by deforming the blanket-type coil unit along the groove in a case where the blanket-type coil unit is wound around the subject. The "parallel direction" does not necessarily mean "parallel" in a strict sense.

A fourteenth embodiment relates to the coil system according to any one of the first aspect or first to thirteenth embodiments, in which a second slit is formed in a body axis direction of the subject on a leg side of the subject in a case where the blanket-type coil unit is wound around the subject. According to the fourteenth embodiment, the degree of close contact between the coil unit and the leg side can be improved in a case of changing the orientation of the leg or the like.

A fifteenth embodiment relates to the coil system according to any one of the first aspect or first to fourteenth embodiments, in which the blanket-type coil unit is a flexible coil unit that is deformable in a plurality of directions within a plane. According to the sixteenth aspect, the coil unit is easily deformed to fit the body shape of the subject, and the degree of close contact between the coil unit and the subject can be improved. In the fifteenth embodiment, it is preferable that the "plurality of directions within the plane" include all directions in the plane, but do not necessarily include all directions.

As described above, with the coil system according to the aspects of the present invention, the fixing operation can be easily performed, and the degree of close contact between the coil unit and the subject can be increased.

### BRIEF DESCRIPTION OF THE DRAWINGS

FIG. 1 is a diagram illustrating a configuration of a coil system according to a first embodiment.
FIGS. 2A and 2B are diagrams illustrating an example of a receive coil unit.
FIG. 3 is a diagram illustrating a state where the receive coil unit and a fixing auxiliary member are coupled to each other.
FIG. 4 is a diagram illustrating a state where the coil system is attached to a subject.
FIG. 5 is a diagram illustrating a state where the fixing auxiliary member is integrated.
FIGS. 6A and 6B are diagrams illustrating a state where the coil system is attached to the subject.
FIG. 7 is a diagram illustrating a state where the coil system is attached to the subject.
FIGS. 8A to 8C are diagrams illustrating an example of the fixing auxiliary member that can be fixed to a bed.
FIG. 9 is a diagram illustrating an example of the fixing auxiliary member made of a material having a mesh structure.
FIG. 10 is a schematic diagram illustrating a state where a receive coil unit in the related art is wound around the subject.

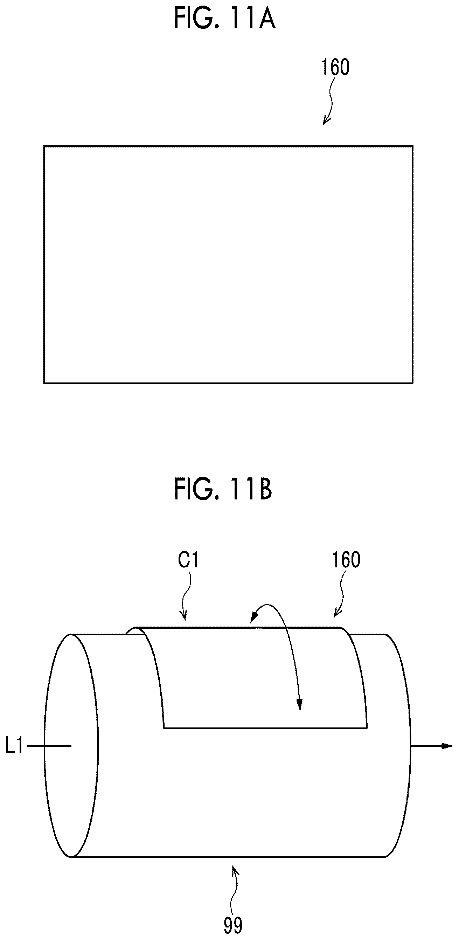

FIGS. 11A and 11B are diagrams illustrating a state where the receive coil unit in the related art is not deformed along a plurality of curved surfaces.
FIG. 12 is a diagram illustrating a state where the receive coil unit in the related art is fixed to a subject by a separate belt.

### DESCRIPTION OF THE PREFERRED EMBODIMENTS

### First Embodiment

A receive coil unit according to a first embodiment is used in a case of acquiring a magnetic resonance image in a magnetic resonance imaging apparatus (MRI apparatus). Therefore, first, an example of a schematic configuration of the MRI apparatus will be described; the MRI apparatus comprises an imaging apparatus body, a bed device, a filter box, a control device, and a power supply device. Among these components, the imaging apparatus body and the bed device are installed in a location (an examination room, an imaging room, or the like) that is radio-wave shielded (and further magnetically shielded as necessary), and the control device is installed in a location different from the examination room or the like and performs communication via the filter box.

The imaging apparatus body comprises a static magnetic field generation source, a gradient magnetic field coil, and an irradiation coil. The imaging apparatus body may be a tunnel-type apparatus having a tunnel-shaped or cylindrical imaging space, or may be an open-type apparatus having an open imaging space. The static magnetic field generation source is a magnet for generating a uniform static magnetic field in a static magnetic field space in which the subject is accommodated, and the gradient magnetic field coil is a coil for generating a gradient magnetic field superimposed on the static magnetic field space. The static magnetic field generation source may be composed of a superconducting magnet (superconducting coil) or a resistive magnet. The irradiation coil is a coil for irradiating a radio frequency (RF) pulse onto the subject to induce nuclear magnetic resonance in the nuclear spins of atoms that constitute the biological tissue of the subject.

The subject is placed on a top plate of the bed device, and the top plate is moved to carry the subject into the imaging space and to carry the subject out of the imaging space. The bed device may be a device in which a height is changeable. Further, the bed device may be fixed to the imaging apparatus body or may be attachable to and detachable from the imaging apparatus body. The filter box is installed between the control device and the examination room in which the imaging apparatus body and the bed device are installed, and the cables connected to the imaging apparatus body and the bed device are connected to the control device via this filter box. The control device comprises a processor, a memory such as a read only memory (ROM) or a random access memory (RAM), and various recording devices and display devices, and reconstructs a magnetic resonance image of the subject using signals received by the receive coil unit.

### Configuration of Coil System

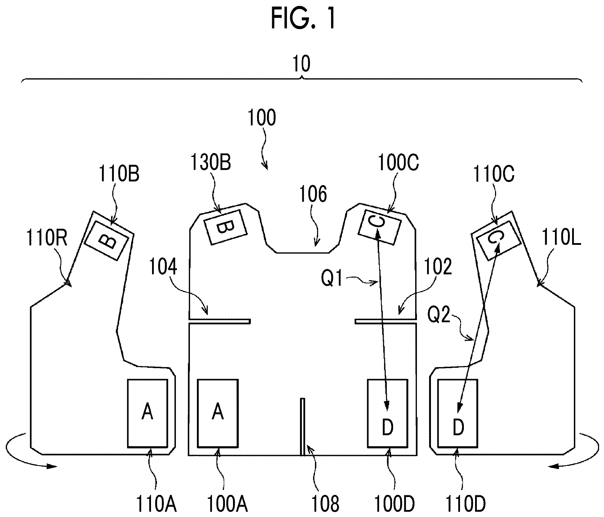

FIG. 1 is a diagram illustrating a configuration of a coil system 10 (coil system) according to the first embodiment. As illustrated in FIG. 1, the coil system 10 comprises a receive coil unit 100 (blanket-type coil unit), a left fixing auxiliary member 110L (fixing auxiliary member, harness), and a right fixing auxiliary member 110R (fixing auxiliary member, harness). The left fixing auxiliary member 110L and the right fixing auxiliary member 110R constitute a plurality of fixing auxiliary members. A fixing member (third fixing member) that fixes the left fixing auxiliary member 110L and the right fixing auxiliary member 110R may be provided. In the following description, in a case where the receive coil unit 100 is attached to the subject, a head side of the subject may be described as "up", a leg side of the subject may be described as "down", a left hand side of the subject may be described as "left", and a right hand side of the subject may be described as "right". The same applies to the left fixing auxiliary member 110L and the right fixing auxiliary member 110R.

### Receive Coil Unit

The receive coil unit 100 is a flexible blanket-type coil unit that is wound around the subject in a case of acquiring the magnetic resonance image, is configured as, for example, a unit comprising a plurality of receive coil elements (element coils) that are formed in a loop shape and are disposed in a two-dimensional array, and receives signals from the subject. The signals received by each element are transmitted to a control device (not illustrated) via a connector 107, and are used for generating the magnetic resonance image. The signals may be transmitted and received via a wireless transceiver antenna. It is preferable that the receive coil unit 100 is a flexible coil unit that is deformable in all directions within a plane.

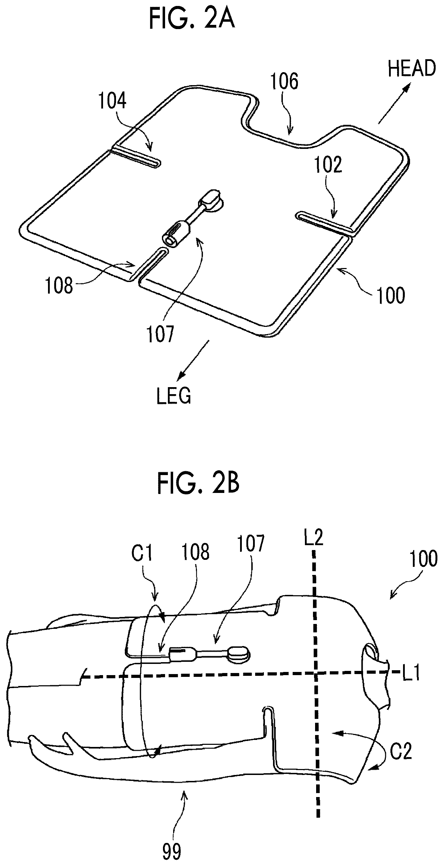

FIGS. 2A and 2B are external views of the receive coil unit 100, and FIG. 2A is a front perspective view of the receive coil unit 100. As illustrated in FIG. 1 and FIGS. 2A and 2B, a pair of first slits 102 and 104 (a pair of first slits) are formed at positions of the left and right sides facing each other in the receive coil unit 100. It is preferable that the first slits 102 and 104 are present on the same straight line, but do not have to be present on the same straight line in a strict sense. The first slits 102 and 104 are provided in a direction (left-right direction) orthogonal (one aspect of intersection) to the body axis of the subject in a case where the receive coil unit 100 is wound around the subject. In addition, a recess 106 (recess, notch) is formed on an upper side of the receive coil unit 100, and a second slit 108 (second slit) is formed on a lower side of the receive coil unit 100 in the body axis direction (up-down direction).

FIG. 2B is a diagram illustrating a state where the receive coil unit 100 is wound around a subject 99. As illustrated in the same drawing, the receive coil unit 100 is deformable into a plurality of curved surfaces having different axes on both sides of the first slits 102 and 104. Specifically, the receive coil unit 100 is deformed into a curved surface C1 (first curved surface) having a body axis L1 as an axis in a region below (on the leg side of) the first slits 102 and 104, and is deformed into a curved surface C2 (second curved surface) having a second axis L2 orthogonal to the body axis L1 (axis of the first curved surface) (one aspect of "intersection") as an axis in a region above (on the head side of) the first slits 102 and 104. Therefore, the receive coil unit 100 can be deformed to fit the body shape (shoulder, abdomen, or the like) of the subject 99 and can be brought into close contact with the subject 99.

In addition, the first slits 102 and 104 are provided on the leg side of the subject 99 in a case where the receive coil unit 100 is wound around the subject 99 with respect to a bottom portion of the recess 106. As a result, the receive coil unit 100 can be wound around the shoulder of the subject 99 while avoiding the neck of the subject 99 along the curved surface C2, and the degree of close contact with the subject 99 can be increased.

In addition, the receive coil unit 100 can be deformed along the second axis L2 and a third axis (axis orthogonal to the axes L1 and L2) in a case where the subject 99 is imaged with the knees bent by the second slit 108, so that the knees are less likely to hit the receive coil unit 100, and a coil of a lower abdominal region is less likely to float or shift with respect to the abdomen of the subject 99. Similarly, in a case where the subject 99 is sitting on a chair or is walking, the knees are less likely to hit the coil, and the operation can be smoothly performed.

A slit opening and closing mechanism may be provided in the first slits 102 and 104 and/or the second slit 108 described above. By opening and closing the slit, the number of axes (the number of curved surfaces) in a case of the deformation can be changed in accordance with a condition such as the body shape of the subject and the imaging part. For example, in a case where the slit opening and closing mechanism for the first slits 102 and 104 is closed, and the receive coil unit 100 is wound around the subject 99, the receive coil unit 100 can be deformed into the curved surface C1 having the body axis L1 as an axis, and can be used as one large receive coil unit that covers the chest to the abdomen. On the other hand, in a case where the first slits 102 and 104 are opened, and the receive coil unit 100 is wound around the subject 99, the receive coil unit 100 can be deformed into the plurality of curved surfaces C1 and C2 having different axes on both sides of the first slits 102 and 104 as described above.

The slit opening and closing mechanism can be composed of a slide fastener, a string fastener, a hook-and-loop fastener, a button, and the like, and the receive coil unit can be deformed into various shapes in accordance with a condition such as the body shape of the subject and the imaging part by such a slit opening and closing mechanism.

### Left Fixing Auxiliary Member and Right Fixing Auxiliary Member

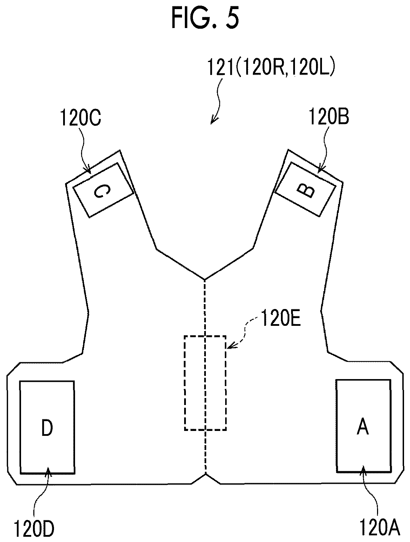

The left fixing auxiliary member 110L and the right fixing auxiliary member 110R are fixing auxiliary members (harnesses) for fixing the receive coil unit 100 in a state where the receive coil unit 100 is wound around the subject, and are attachable to and detachable from the receive coil unit 100. In FIG. 1, a fixing auxiliary member located on the left side of the subject in a case where the fixing auxiliary member is wound around the subject is described as a left fixing auxiliary member 110L, and a fixing auxiliary member located on the right side of the subject in a case where the fixing auxiliary member is wound around the subject is described as a right fixing auxiliary member 110R. In FIG. 1, the fixing auxiliary member is displayed with its front and back sides reversed in order to clarify the correspondence between the fixing member of the fixing auxiliary member and the fixing member of the receive coil unit 100. In the state of FIG. 1, a fixing member (third fixing member) that fixes the left fixing auxiliary member 110L and the right fixing auxiliary member 110R may be provided at a right end portion of the left fixing auxiliary member 110L and a left end portion of the right fixing auxiliary member 110R (near the spine of the subject) (see an example of FIG. 5).

### Fixing of Receive Coil Unit and Fixing Auxiliary Member by Fixing Member

In the coil system 10, the fixing member is provided in the receive coil unit 100, the left fixing auxiliary member 110L, and the right fixing auxiliary member 110R, and the receive coil unit 100, the left fixing auxiliary member 110L, and the right fixing auxiliary member 110R are fixed to each other by coupling these fixing members to each other. In the receive coil unit 100, the first fixing members 100A to 100D (first fixing members) are provided at at least four locations in total (both shoulders and both flanks in a case where the receive coil unit 100 is wound around the subject) of both end portions in the body axis direction (up-down direction) and both end portions in a direction (left-right direction) orthogonal to the body axis direction in a case where the receive coil unit 100 is wound around the subject.

On the other hand, in the left fixing auxiliary member 110L, the second fixing members 110C and 110D (second fixing members) are provided at both end portions in the body axis direction (up-down direction) in a case where left fixing auxiliary member 110L is wound around the subject, and in the right fixing auxiliary member 110R, the second fixing members 110A and 110B (second fixing members) are provided at both end portions in the body axis direction (up-down direction) in a case where right fixing auxiliary member 110R is wound around the subject. The positions of the second fixing members are four locations in total, including two positions on the left fixing auxiliary member and two positions on the right fixing auxiliary member, and these second fixing members are provided at positions corresponding to the positions of the first fixing members. The number of the second fixing members (four locations in total) is counted by including the left and right fixing auxiliary members.

In a case where a distance between the first fixing members at both end portions in the body axis direction (center-to-center distance between the first fixing members 100C and 100D) in the receive coil unit 100 is defined as a distance Q1, and a distance between the second fixing members at both end portions in the body axis direction (center-to-center distance between the second fixing members 110C and 110D) in the left fixing auxiliary member 110L and the right fixing auxiliary member 110R is defined as a distance Q2, the distance Q2 is shorter than the distance Q1 (distance Q2 < distance Q1). As a result, the receive coil unit 100 can be pulled in by the left fixing auxiliary member 110L and the right fixing auxiliary member 110R having a short body axis direction length, and the degree of close contact with the subject can be improved. Such a relationship between the distances between the fixing members is also the same for the center-to-center distance between the first fixing members 100A and 100B and the center-to-center distance between the second fixing members 110A and 110B.

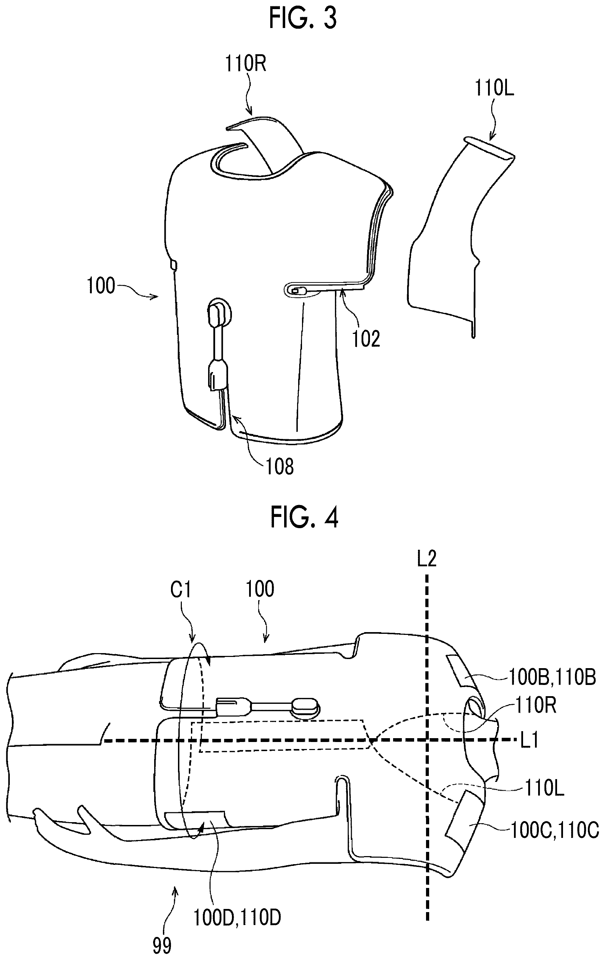

FIG. 3 is a diagram illustrating a state where the receive coil unit 100, the left fixing auxiliary member 110L, and the right fixing auxiliary member 110R are connected to each other, and FIG. 4 is a diagram illustrating a state where the coil system 10 is attached to the subject 99. In FIG. 3, the first fixing members 100A to 100D and the second fixing members 110A to 110D are not illustrated, and in FIG. 4, the first fixing member 100A and the second fixing member 110A are not illustrated. In the coil system 10, the receive coil unit 100, the left fixing auxiliary member 110L, and the right fixing auxiliary member 110R are fixed to each other by the fixing member by the above configuration. In addition, the receive coil unit 100 can be deformed into different curved surfaces on the upper side and the lower side of the first slits 102 and 104. Specifically, the receive coil unit 100 can be deformed into the curved surface C1 having the body axis L1 as an axis in the abdominal region (region on the leg side of the subject 99) and can be deformed into the curved surface C2 having the second axis L2 as an axis in the shoulder region (region on the head side). As described above, in the coil system 10, the receive coil unit 100 can be deformed to fit the body shape of the subject 99, and the degree of close contact between the receive coil unit 100 and the subject 99 can be improved.

It is preferable that the receive coil unit 100 is a flexible coil unit that is deformable in all directions within the plane, but the receive coil unit 100 can be used in the aspects of FIGS. 3 and 4 as long as the receive coil unit 100 is deformable along at least a plurality of directions (for example, two axes of the body axis L1 and the second axis L2).

### Specific Aspect of Fixing Member

In the coil system 10, a hook-and-loop fastener, a button, an adjuster (one of the first fixing member or the second fixing member has a hole and the other has a protrusion corresponding to the hole), or the like can be used as the first fixing members 100A to 100D and the second fixing members 110A to 110D. The shape, the size, the disposition, and the number of these fixing members may be changed as appropriate, and it is preferable that the degree of close contact between the receive coil unit 100 and the subject 99 can be adjusted by changing these conditions.

### Integration of Fixing Auxiliary Member

FIG. 5 is a diagram illustrating a state where the fixing auxiliary member is integrated. A fixing auxiliary member 121 (fixing auxiliary member, harness) illustrated in FIG. 5 is configured by integrating the left and right fixing auxiliary members, and the second fixing members 120A to 120D (second fixing members) are provided at at least four locations in total, including both end portions in the body axis L1 direction and both end portions in a direction orthogonal to the body axis L1 direction in a case where the fixing auxiliary member 121 is wound around the subject, as in the left fixing auxiliary member 110L and the right fixing auxiliary member 110R described above. The second fixing members 120A to 120D are provided at positions corresponding to the first fixing members 100A to 100D of the receive coil unit 100 (the relationship between the distances between the fixing members is also the same as described above), and thus the receive coil unit 100 can be brought into close contact with the subject 99 even in a case where the integrated fixing auxiliary member 121 is used. As in the first fixing members 100A to 100D and the second fixing members 110A to 110D described above, a hook-and-loop fastener, a button, an adjuster, and the like can be used as the second fixing members 120A to 120D.

In FIG. 5, the integrated fixing auxiliary member 121 is illustrated, but in a case where the fixing auxiliary member 121 is separated into two fixing auxiliary members (separated in a longitudinal direction of FIG. 5 at the center of the fixing auxiliary member 121 in the left-right direction; body axis L1 direction), the two fixing auxiliary members serve as a left fixing auxiliary member 120L and a right fixing auxiliary member 120R (a plurality of fixing auxiliary members). In this case, a fixing member 120E (hook-and-loop fastener, button, adjuster, and the like; third fixing member) for coupling the left fixing auxiliary member 120L and the right fixing auxiliary member 120R to be used as one integrated member may be provided.

### Attachment of Coil System to Subject

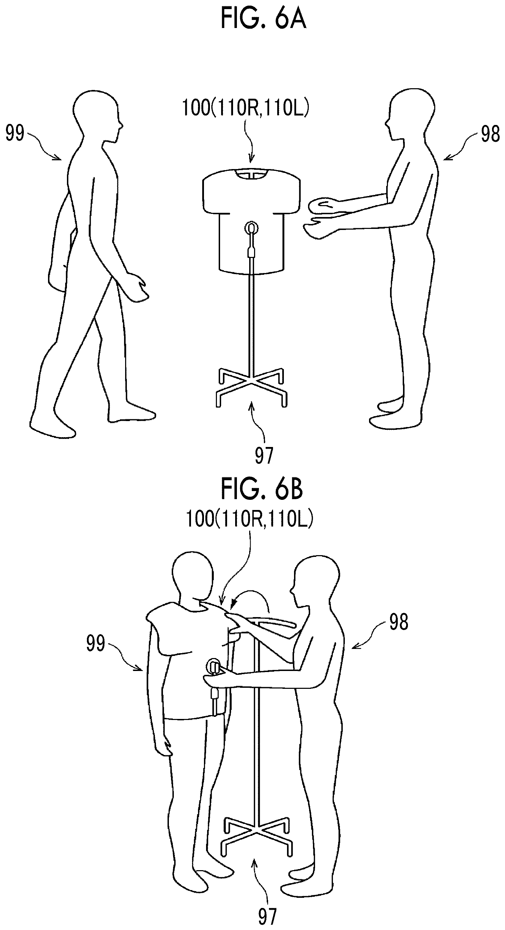

FIGS. 6A and 6B are diagrams illustrating a state where the coil system 10 is attached to the subject 99. FIG. 6A illustrates a state where the coil system 10 is set on a hanger 97 and the subject 99 has arrived at a location where an assistant 98 (doctor, technician, nurse, or the like) is on standby, and FIG. 6B illustrates a state where the assistant 98 attaches the coil system 10 to the subject 99 (state as viewed from a diagonal front side). In the example of FIGS. 6A and 6B, the assistant 98 winds the receive coil unit 100 around the chest and the abdomen of the subject 99, but the subject 99 may perform this operation by himself/herself.

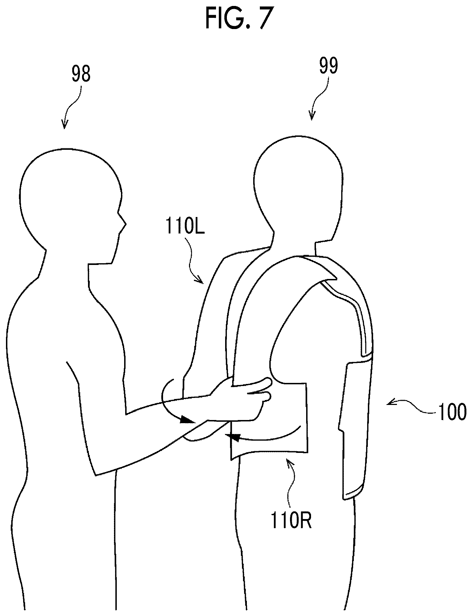

FIG. 7 is another diagram illustrating a state where the coil system 10 is attached to the subject 99 (state as viewed from a diagonal rear side). The same drawing illustrates a state where the first fixing members 100B and 100C and the second fixing members 110B and 110C described above are fixed to each other, and the first fixing members 100A and 100D and the second fixing members 110A and 110D are fixed to each other. The assistant 98 winds the left fixing auxiliary member 110L and the right fixing auxiliary member 110R on a back side of the subject 99. As a result, in the coil system 10, the receive coil unit 100 can be pulled in by the left fixing auxiliary member 110L and the right fixing auxiliary member 110R having a short body axis direction length, and the degree of close contact with the subject can be improved. In a case of the attachment, the left fixing auxiliary member 110L and the right fixing auxiliary member 110R may be fixed to each other by the fixing member (third fixing member) (see the example of FIG. 5).

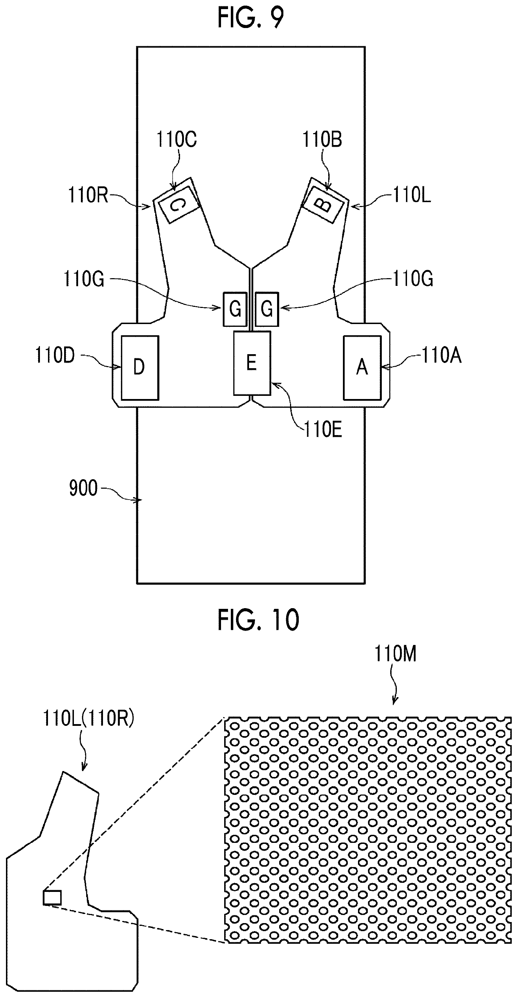

As described above, in the coil system 10 according to the present embodiment, the coil system 10 can be attached (wound) in a state where the subject 99 is standing (the attachment operation can be performed in the same manner even in a state where the subject 99 is sitting), and the attachment operation can be easily performed by the fixing member. The coil system according to the embodiment of the present invention can also respond to the subject who has difficulty in attachment in a standing state (see a modification example described below with reference to FIG. 9).

### Modification Example

### Aspect of Providing Fold in Coil Unit

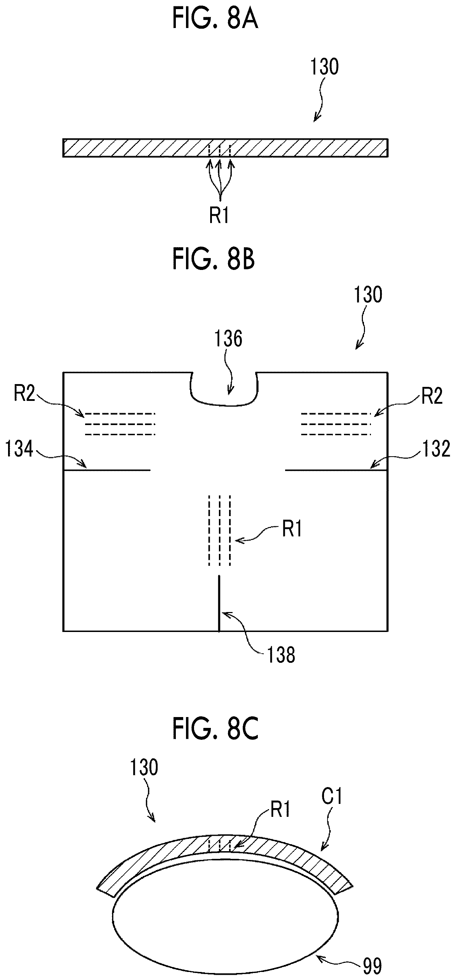

In the receive coil unit according to the embodiment of the present invention, a fold (groove) may be provided in a direction parallel to an axis of at least one curved surface among the plurality of curved surfaces (the plurality of curved surfaces having different axes in which the receive coil unit is deformable; the curved surfaces C1 and C2 of FIGS. 2A and 2B). This "direction parallel to the axis of the at least one curved surface" may be the body axis direction and/or the direction orthogonal to the body axis (second axis direction). FIGS. 8A to 8C are diagrams illustrating an example of the receive coil unit in which such a fold is provided. FIG. 8A is a cross-sectional view of a receive coil unit 130, and is a diagram illustrating a state where a fold R1 (groove) is formed. The fold R1 is, for example, a groove formed in the direction parallel to the body axis L1. This groove can have a shape that is narrow on an upper side of the drawing and wide on a lower side of the drawing, such as an inverted V-shape, an inverted U-shape, a semicircular shape, or a semi-elliptical shape. In addition, FIG. 8B is a front view illustrating a state where folds R1 and R2 are formed in the receive coil unit 130. In the example illustrated in the same drawing, the fold R1 is formed in the direction parallel to the body axis L1, and folds R2 and R3 (grooves) are formed in the direction parallel to the axis L2 intersecting (orthogonal to) the body axis L1. The folds R1, R2, and R3 are provided at the lower part (leg side) and the upper part (head side) of the receive coil unit 130, respectively. Only one of the fold R1, R2, or R3 may be provided, or two or more of the folds R1, R2, and R3 may be provided. In the receive coil unit 130, the first slits 132 and 134 (a pair of first slits) and the second slit 138 (second slit) and the recess 136 (recess) on the head side of the subject are provided.

As illustrated in FIG. 8C (cross-sectional view, schematic view), in a case where the receive coil unit 130 is wound around the subject 99, the lower part of the receive coil unit 130 is easily deformed along the fold R1, and it is easy to form the curved surface C1 (first curved surface) having the fold R1 as a vertex (or near the vertex). In addition, the upper part of the receive coil unit 130 is easily deformed along the folds R2 and R3, and it is easy to form a curved surface (the curved surface C2 of FIGS. 2A and 2B and FIG. 4; second curved surface) having the folds R2 and R3 as vertices (or near the vertices).

As described above, by providing the fold in the direction parallel to the axis of at least one curved surface among the plurality of curved surfaces, the receive coil unit 130 is easily deformed into the curved surface having the direction as an axis, and it is easy to fit the body shape of the subject 99, and the degree of close contact between the coil and the subject can be improved. The fold may be formed on the back surface or the front surface of the receive coil unit 130. In addition, such a fold may be applied to a receive coil unit having another configuration, such as the receive coil unit 100 (the same applies to the coil system including the fixing auxiliary member).

### Aspect of Fixing Bed and Fixing Auxiliary Member to Each Other

FIG. 9 is a diagram illustrating an example in which a fixing member 110G (fourth fixing member; hook-and-loop fastener and the like) for fixing the left fixing auxiliary member 110L and the right fixing auxiliary member 110R to a bed 900 of the MRI apparatus is provided. A fixing member (hook-and-loop fastener and the like) corresponding to the fixing member 110G can also be provided on the bed 900. According to the aspect illustrated in FIG. 9, the fixing auxiliary member (harness) can be fixed to the bed in advance, and it is easy to perform the operation of attaching the coil system even in a subject who has difficulty in performing the operation of attaching the coil system in a standing state (or with his/her upper body raised).

### Aspect of Fixing Auxiliary Member Having Region of Mesh Structure

FIG. 10 is a diagram illustrating an example of the fixing auxiliary member (left fixing auxiliary member 110L) having a mesh region 110M of the mesh structure. With such a mesh structure, the ventilation property of the fixing auxiliary member is improved, and it is possible to reduce the possibility that the subject unintentionally moves due to discomfort and affects the imaging. The position, the shape, the size, and the number of the mesh structures are not particularly limited. In addition, the same applies to the right fixing auxiliary member 110R and the integrated fixing auxiliary member.

The embodiment and the modification examples of the present invention have been described above, but the present invention is not limited to the aspects described above, and various modifications can be made.

### Explanation of References

10: coil system 97: hanger
98: assistant
99: subject
100: receive coil unit
100A: first fixing member
100B: first fixing member
100C: first fixing member
100D: first fixing member
102: first slit
104: first slit
106: recess
107: connector
108: second slit
110A: second fixing member
110B: second fixing member
110C: second fixing member
110D: second fixing member
110G: fixing member
110L: left fixing auxiliary member
110M: mesh region
110R: right fixing auxiliary member
120: fixing auxiliary member
120A: second fixing member
120B: second fixing member
120C: second fixing member
120D: second fixing member
120E: fixing member
120L: left fixing auxiliary member
120R: right fixing auxiliary member
121: fixing auxiliary member
130: receive coil unit
132: first slit
134: first slit
136: recess
138: second slit
160: receive coil
900: bed

## Claims

1. A coil system (10) comprising:
a flexible blanket-type coil unit (100, 130) that is wound around a subject (99) in a case of acquiring a magnetic resonance image; and
a fixing auxiliary member (110L, 110R, 120, 120L, 120R, 121) that is attachable to and detachable from the blanket-type coil unit (100, 130) and that is used for fixing the blanket-type coil unit (100, 130) in a state where the blanket-type coil unit (100, 130) is wound around the subject (99),
wherein the blanket-type coil unit (100, 130) is provided with a first fixing member (100A, 100B, 100C, 100D) for connection to the fixing auxiliary member (110L, 110R, 120, 120L, 120R, 121),
the fixing auxiliary member (110L, 110R, 120, 120L, 120R, 121) is provided with a second fixing member (110A, 110B, 110C, 110D, 120A, 120B, 120C, 120D) for connection to the blanket-type coil unit (100, 130), and
the blanket-type coil unit (100, 130) and the fixing auxiliary member (110L, 110R, 120, 120L, 120R, 121) are fixed to each other by fixing the first fixing member (100A, 100B, 100C, 100D) and the second fixing member (110A, 110B, 110C, 110D, 120A, 120B, 120C, 120D).

2. The coil system (10) according to claim 1,
wherein the blanket-type coil unit (100, 130) is provided with the first fixing members (100A, 100B, 100C, 100D) at at least four locations in total, including both end portions in a body axis direction in a case where the blanket-type coil unit (100, 130) is wound around the subject (99) and both end portions in a direction intersecting the body axis direction,
the fixing auxiliary member (110L, 110R, 120, 120L, 120R, 121) is provided with the second fixing members (110A, 110B, 110C, 110D, 120A, 120B, 120C, 120D) at at least four locations in total, including both end portions in the body axis direction in a case where the fixing auxiliary member (110L, 110R, 120, 120L, 120R, 121) is wound around the subject (99) and both end portions in the direction intersecting the body axis direction,
positions of the second fixing members (110A, 110B, 110C, 110D, 120A, 120B, 120C, 120D) correspond to positions of the first fixing members (100A, 100B, 100C, 100D), and
the blanket-type coil unit (100, 130) and the fixing auxiliary member (110L, 110R, 120, 120L, 120R, 121) are fixed to each other by coupling the first fixing members (100A, 100B, 100C, 100D) and the second fixing members (110A, 110B, 110C, 110D, 120A, 120B, 120C, 120D).

3. The coil system (10) according to claim 2,
wherein a distance between the second fixing members (110A, 110B, 110C, 110D, 120A, 120B, 120C, 120D) at both end portions of the fixing auxiliary member (110L, 110R, 120, 120L, 120R, 121) in the body axis direction is shorter than a distance between the first fixing members (100A, 100B, 100C, 100D) at both end portions of the blanket-type coil unit (100, 130) in the body axis direction.

4. The coil system (10) according to any one of claims 1 to 3,
wherein the first fixing member (100A, 100B, 100C, 100D) and the second fixing member (110A, 110B, 110C, 110D, 120A, 120B, 120C, 120D) are hook-and-loop fasteners.

5. The coil system (10) according to any one of claims 1 to 4,
wherein the fixing auxiliary member (110L, 110R, 120, 120L, 120R, 121) is composed of a plurality of fixing auxiliary members, and the plurality of fixing auxiliary members are fixed to each other by a third fixing member (110E, 120E).

6. The coil system (10) according to any one of claims 1 to 5,
wherein the fixing auxiliary member (110L, 110R, 120, 120L, 120R, 121) has a fourth fixing member (110G) for fixing the coil system (10) to a bed (900) of a magnetic resonance imaging apparatus.

7. The coil system (10) according to any one of claims 1 to 6,
wherein the fixing auxiliary member (110L, 110R, 120, 120L, 120R, 121) has a mesh structure region (110M).

8. The coil system (10) according to any one of claims 1 to 7,
wherein a recess (106, 136) is formed on a head side of the subject (99) in a case where the blanket-type coil unit (100, 130) is wound around the subject (99).

9. The coil system (10) according to any one of claims 1 to 8,
wherein the blanket-type coil unit (100, 130)
is provided with a pair of first slits (102, 104, 132, 134) at facing positions, and
is deformable into a plurality of curved surfaces having different axes on both sides of the first slits (102, 104, 132, 134), and
preferably, the pair of first slits (102, 104, 132, 134) are present on the same straight line.

10. The coil system (10) according to claim 9,
wherein the pair of first slits (102, 104, 132, 134) are provided in a direction intersecting a body axis of the subject (99) in a case where the blanket-type coil unit (100, 130) is wound around the subject (99).

11. The coil system (10) according to claim 9 or 10,
wherein in a case where the blanket-type coil unit (100, 130) is wound around the subject (99),
the blanket-type coil unit (100, 130)
is deformable into a first curved surface having an axis in a body axis direction of the subject (99) in one region of the first slits (102, 104, 132, 134), and
is deformable into a second curved surface having an axis in a direction intersecting the axis of the first curved surface in the other region of the first slits (102, 104, 132, 134).

12. The coil system (10) according to any one of claims 9 to 11,
wherein a recess (106, 136) is formed in the blanket-type coil unit (100, 130) on a head side of the subject (99) in a case where the blanket-type coil unit (100, 130) is wound around the subject (99), and
the pair of first slits (102, 104, 132, 134) are provided on a leg side of the subject (99) in a case where the blanket-type coil unit (100, 130) is wound around the subject (99), with respect to a bottom portion of the recess (106, 136).

13. The coil system (10) according to any one of claims 9 to 12,
wherein a groove is provided in a direction of an axis of at least one curved surface among the plurality of curved surfaces, and a curved surface having a vertex at the groove is formed by deforming the blanket-type coil unit (100, 130) along the groove in a case where the blanket-type coil unit (100, 130) is wound around the subject (99).

14. The coil system (10) according to any one of claims 1 to 13,
wherein a second slit (108, 138) is formed in a body axis direction of the subject (99) on a leg side of the subject (99) in a case where the blanket-type coil unit (100, 130) is wound around the subject (99).

15. The coil system (10) according to any one of claims 1 to 14,
wherein the blanket-type coil unit (100, 130) is a flexible coil unit that is deformable in a plurality of directions within a plane.
